## Europäisches Patentamt
## European Patent Office
## Office européen des brevets

(11) Publication number: **0 130 866**
**B1**

(12) **EUROPEAN PATENT SPECIFICATION**

(45) Date of publication of patent specification: **02.03.88**

(51) Int. Cl.⁴: **H 01 L 21/306**, H 01 L 21/68, C 23 F 1/08

(21) Application number: **84401133.8**

(22) Date of filing: **05.06.84**

(54) Apparatus and installation for the wet processing of planar substrates.

(30) Priority: **29.06.83 JP 117364/83**

(43) Date of publication of application:
**09.01.85 Bulletin 85/02**

(45) Publication of the grant of the patent:
**02.03.88 Bulletin 88/09**

(84) Designated Contracting States:
**DE FR GB**

(56) References cited:
**EP-A-0 044 567**
**CH-A- 390 397**
**US-A-3 630 804**

**IBM TECHNICAL DISCLOSURE BULLETIN, vol. 16, no. 9, February 1974, New York, USA; H.G. BICKFORD et al. "Semiconductor wafer wet processing rotating apparatus", page 2788**
**Patent Abstracts of Japan, vol. 6, no. 191, 30 september 1982**

(73) Proprietor: **FUJITSU LIMITED**
**1015, Kamikodanaka Nakahara-ku**
**Kawasaki-shi Kanagawa 211 (JP)**

(72) Inventor: **Ohkuma, Yuji**
**878, Shimonoge Takatsu-ku**
**Kawasaki-shi Kanagawa, 213 (JP)**

(74) Representative: **Descourtieux, Philippe et al**
**CABINET BEAU de LOMENIE 55 rue d'Amsterdam**
**F-75008 Paris (FR)**

Courier Press, Leamington Spa, England.

## Description

This invention is related to an apparatus and an installation for wet processing and is particularly applicable to the washing or etching of substrates for the fabrication of semiconductor devices. The present invention aims to provide an apparatus and installation which can process the substrates continuously one by one.

In semiconductor manufacturing many wet processes are used, such as washing and etching of substrates. For carrying out such processes it is known to use a batch process, namely to place a plurality of substrates into a bucket for etching, or to place the substrates on a rack and immerse them into an etchant. In such a batch process it is difficult to control the etching with accuracy, because, while the etchant in the bucket is replaced by water or the rack is taken out from the etchant and immersed into water, the etching of the substrates continues. Moreover, it is difficult to process the surface uniformly, since the etchant trickles from one side of the substrate when the substrate is lifted up from the etchant.

In some cases, the surfaces of the substrates are polluted or oxidized by air when moved from one processing place to the next. Therefore, if the progress of a process is delayed for some reason, preprocessing is required once more. All this has undesirable influences on the yield and dispersion of the characteristics of the products.

In order to overcome such problems, the process for fabricating semiconductor devices has changed from batch processing to one-by-one processing.

Basically, the one-by-one chemical processing consists in holding the substrate with a chuck and treating the substrate in a cup containing the chemicals (cup treatment), or spraying the chemicals on the surface of the substrate (spray treatment).

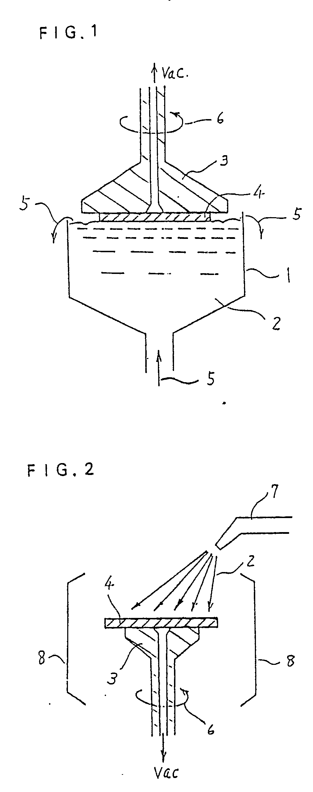

One example of a cup treatment is shown schematically in Fig. 1. A cup 1 is filled with the chemicals constituting the etchant, or with water, 2 which is introduced from the bottom of cup 1 and overflows from the edge of cup 1. The arrow line 5 indicate the direction of the stream of etchant or water. A substrate is fixed to a chuck 3, by vacuum for example, and is immersed into the etchant 1. The chuck 3 is rotated around its axis as shown by the arrow line 6, in order to uniformly treat the surface of the substrate.

A typical example of spray treatment is shown schematically in Fig. 2. The substrate 4 is fixed on the chuck 3 and rotated around the axis as indicated by arrow 6. The chemicals or water 2 are sprayed on the surface of substrate 4 from a nozzle 7. A cover 8 is provided to prevent the splash of chemicals.

In such prior art systems where the substrates or slices to be processed are held by vacuum chucks, for example, it is impossible to treat both sides of the slice at the same time. Therefore, said systems cannot be used to carry out specific treatments which require to treat both sides of the slices at the same time.

In IBM Technical Disclosure Bulletin Vol. 16, No. 9 February 1974, a semiconductor wafer wet processing rotating apparatus is proposed having a processing chamber with liquid injecting means opening in the lower and upper parts of the chamber to cause the wafer to be uniformly processed while being rotated by streams of liquid injected into the processing chamber in a direction aslant to the direction of rotation of the wafer.

The object of the invention is to provide an improved wet processing apparatus of this type, in particular for continuously treating planar substrates one by one with increased accuracy and uniformity of wet processing over the entire surface of the substrate.

According to the invention, this object is reached by means of a wet processing apparatus with a processing chamber which comprises:

— a pedestal on which the substrate is processed and comprising: a first opening provided at the centre of the pedestal, for injecting processing liquid into the processing chamber through said first opening; a plurality of nozzles provided around said first opening and through which processing liquid is injected into the processing chamber, said nozzles being aslant to the direction of rotation of the substrate; and a channel through which processing liquid is supplied to each of said nozzles, said channel having a second opening through which processing liquid is admitted; and

— a lid for covering the pedestal and comprising: a third opening through which processing liquid is injected into the processing chamber; and exhaust openings arranged on the periphery of the lid and through which the processing liquid overflows,

— whereby the substrate is floated in the processing liquid while being rotated around its axis.

When the treatment is completed, the processing liquid is switched to pure water. Then, the substrates are conveyed one by one by a stream of water forming a conveyor system. As the substrate proceeds along the water conveyor (or water bearing) it is washed and cleaned by spraying water over it.

At the end of the water conveyor or bearing, there is provided a spin dryer. When the substrate is positioned, a shutter closes and separates the spin dryer from the washing zone. Then the water in the spin dryer is extracted and the chuck of the dryer holds the substrate, and begins to rotate. Thus, the substrate is dried quickly.

With the above described process, the wet processed substrate is not exposed to the air until just before the next process begins. Therefore, the surface of the substrate, which is often very active after a chemical process, is protected from poisoning or pollutions by the ambient air.

Further details and merits of the present invention will become clear from the following description and the accompanying drawings.

Fig. 1 illustrates schematically the principle of a prior art bottle-type wet processing apparatus.

Fig. 2 illustrates schematically the principle of a prior art shower-type wet processing apparatus.

Fig. 3(A) illustrates schematically the principle of an apparatus for wet processing according to the present invention, showing a cross-sectional view of its main part.

Fig. 3(B) is a block diagram showing the flow control system for the apparatus of Fig. 3(A).

Fig. 4 illustrates schematically how the substrates are floated and rotated by liquid stream, in particular:

Fig. 4(A) is a plan view of the apparatus of Fig. 3(A), showing the nozzles arrangement; and

Fig. 4(B) is a cross-sectional view of the nozzle part.

Fig. 5 illustrates schematically an installation for wet processing which conveys and treats substrates one by one, according to the present invention.

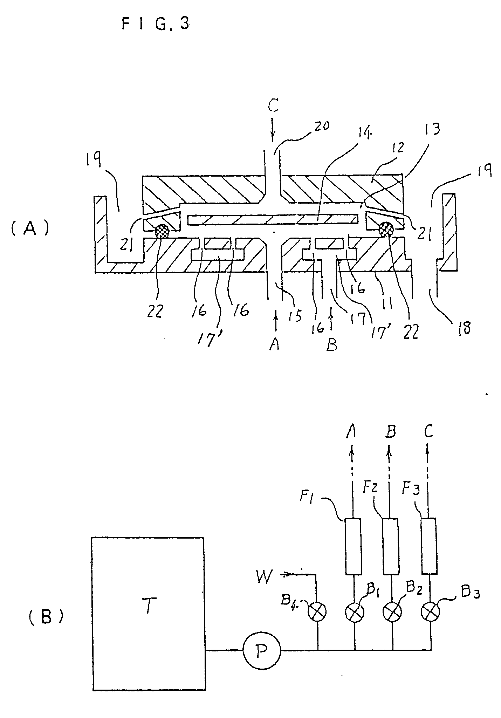

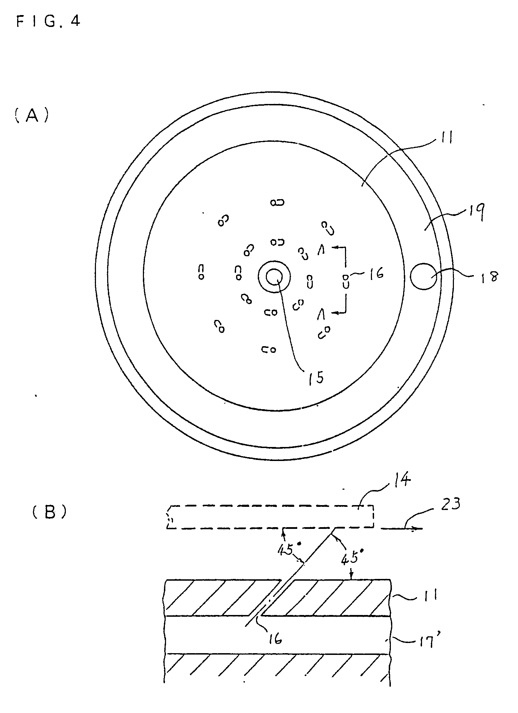

Fig. 3 is a schematical diagram illustrating the principle of an apparatus for wet processing according to the present invention. In Fig. 3, (A) is a cross sectional view of the main part of the apparatus which is circular-shaped. As shown in this figure, a pedestal 11 and its cover 12 forms a circular processing chamber 13. The plan view of the pedestal 11 is shown in Fig. 4(A). The substrate to be processed 14 (a semiconductor substrate for example) is placed in the processing chamber 13. Processing liquid is spouted by pump toward the back surface of the substrate 14 from an opening 15 formed at the center of the pedestal 11, and, the substrate 14 is lifted up to the surface of the liquid by the stream of processing liquid.

The processing liquid may be water, chemical etchant or other, depending on whether the process consists in washing, etching or some other treatment of the substrate.

Around the opening 15 and concentrically therewith are located a plurality of small nozzles 16, which are formed in the pedestal 11 aslant to the bottom surface of the pedestal. The inclinations of these nozzles follow a definite direction around the opening 15 as shown in Fig. 4(A). Fig. 4(B) shows a partial cross-sectional view of a nozzle taken along arrowed line AA of Fig. 4(A). As shown in Fig. 4(B), the nozzle 16 is for example 45° aslant to the bottom surface of the pedestal 11, and all of said nozzles 16 are aslant in an anticlockwise direction, for example, around the opening 15.

Said nozzles 16 are branched from a channel 17' which is provided under the bottom of the pedestal, and communicate with a second opening 17 formed in the pedestal 11 and through which the processing liquid is pumped in. As shown in Figure 3, the channel 17' is arranged circularly around opening 15 and housed in the pedestal 11. The processing liquid runs through the second opening 17, the channel 17' and the nozzles 16, and impinges aslant to the back surface of the substrate 14; thus the substrate 14 is moved in the direction shown by arrow 23. Since a plurality of nozzles 16 are provided around the center opening 15 aslant in one rotational direction, the substrate 14 is rotated around its center by the jet streams flowing out of the nozzles 16.

A cover 12 is provided over the pedestal 11, which covers the pedestal together with an O-ring 22, and forms a processing chamber 13. The O-ring seals the gap between the pedestal 11 and the cover 12. The pedestal 11, cover 12 and O-ring 22 are made from a material which is not stained by the processing liquid, such as, for example a vinyl chloride resin. Glass or acrylic resin may also be used in order to observe the behavior of the substrate inside the processing chamber. Care must be taken that the material used is not stained by the processing chemicals.

Referring back to Fig. 3(A), it can be seen that the cover 12 is provided at its center with a third opening 20, through which the processing liquid is poured or sprayed over the surface of the substrate 14, and the substrate is processed. A plurality of exhaust openings 21 are provided on the periphery of the cover 12. The used processing liquid is discharged from exhaust openings 21 together with any gases which may be generated during the processing (etching for example).

A ditch 19 is provided around the pedestal 11 to collect the overflowing liquid and exhausts through an exhaust pipe 18. In some cases the liquid collected at the output of exhaust pipe 18 may be re-used by circulating it by way of a pump towards openings 15, 17 or 20.

Fig. 3(B) shows an embodiment of the piping system to supply the processing liquid to the above described processing apparatus. In this Figure, T designates a tank for storing the processing liquid. P is a pump for running the liquid. $B_1$, $B_2$, $B_3$ and $F_1$, $F_2$, $F_3$ are respectively, control valves and flow meters. W designates a water inlet and $B_4$ is a stop valve. The outlets A, B and C of the respective flow meters $F_1$, $F_2$ and $F_3$ are connected to the first, second and third openings 15, 16 and 20 in Fig. 3(A). The arrow lines A, B and C show the direction of liquid flow.

Liquid flows A, B and C are respectively controlled by control valves $B_1$, $B_2$ and $B_3$ to a predetermined value indicated in each flow meters $F_1$, $F_2$ and $F_3$. These values are determined beforehand by experiments to float and keep the substrate in the middle of the processing chamber 13, and to rotate it about its axis with a prefabricated speed. Once such flow rate has been determined, it is unnecessary to further adjust the control valves. An example of the water flow required to keep a silicon substrate, having a 102 mm (4-inch) diameter and a 0.5 mm thickness approximately, in the center of the processing chamber whose diameter is 116 mm, is approximately 0.3 1, and 0.5 l-min for A, B and C flow, respectively. With the above conditions, the substrate is rotated in water with a speed of approximately 40 turns/min.

When using the above described processing apparatus, the substrate 14 is placed on the pedestal 11, the cover 12 is pressed down on the O-ring 22 and the processing chamber 13 is sealed. Then the processing chamber 13 is filled with a processing liquid (water or chemicals) through openings 15, 16 and 20. The substrate 14 is floated in the processing liquid almost in the center of the processing chamber 13, by mainly adjusting the streams from openings 15 and 20. The substrate is rotated around its center axis, with a rotating speed of 30 to 60 turns/min, by adjusting the jet streams from the nozzles 16, through control of flow B (Fig. 3). The substrate is processed uniformly by the streams of processing liquid.

When the processing is completed, the processing liquid is switched from chemical to water. This is done very quickly compared to the ordinary batch system, so that there is no problem of over-processing such as over-etching.

For example, after etching silicon dioxide films coating a silicon substrate having a 4-inch diameter with hydrofluoric acid, no difference in etching depth on both surfaces of the substrate was found. Moreover, the etching rate was increased by about 10% compared to ordinary batch processing.

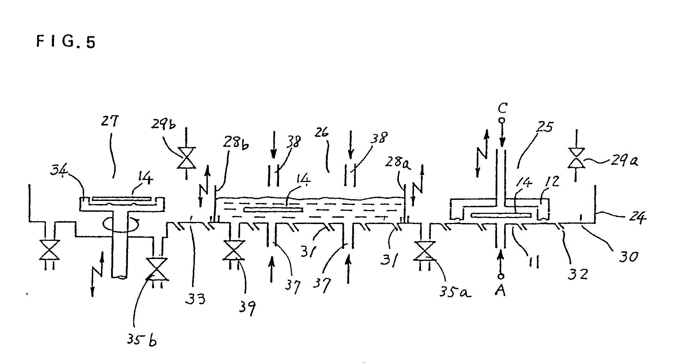

Fig. 5 shows an example of a wet processing installation according to the present invention which is installed in a line for chemical processing of substrates. The processing line is composed of a substrate transfer apparatus 24, a wet processing apparatus according to the present invention 25, a conventional washing apparatus 26 and a conventional centrifugal spin dryer 27.

In this example, the substrate 14 is transferred by a water bearing system, which is similar to an air bearing or air conveyor system. Namely, the substrate is transferred in a stream of water by jet streams of water injected into the stream aslant to the direction of transfer. Shutters 28a and 28b are provided between apparatus 25, 26 and 27.

The substrates are placed one by one on a pedestal 11, which composes part of the base of the transfer apparatus 24, by an appropriate transfer robot (not shown). They could equally be placed manually. The cover 12 is pressed down, and a wet processing as described above is performed by means of the processing apparatus 25 according to the present invention. When the chemical processing is completed, the processing liquid is switched to water and preliminary washing is performed. This preliminary washing has an effect of quenching the chemical process (etching process for example) and prevents over-processing.

Then a water valve 29a is opened and pure water is poured into the first bucket 30 which contains the wet processing apparatus 25. It is not always necessary to provide a water inlet to the first bucket. Water may be poured into the first bucket through openings A, C or nozzles 32 which correspond to those shown in Fig. 3(A).

When the level of water in said bucket reaches that in the washing apparatus 26, the shutter 28a is opened and the two water streams, in bucket 30 and washing apparatus 26, are joined; then the substrate is transferred into the washing apparatus 26, by water jets from nozzles 32 and 31. At this time, it is preferable to keep the level of the water in bucket 30 a little lower than that of the water in the washing apparatus 26. This small difference of water levels prevents the water in bucket 30 (which is still contaminated with processing chemicals) from rushing into the washing apparatus 26 (which is filled with pure water). After that, the shutter 28a and water valve 29a are closed again, and the water in bucket 30 is extracted through an exhaust valve 35a. Then, the cover 12 is lifted and water is then fed into the wet processing apparatus 25, and the same processing cycle is repeated.

During this time, the substrate 14 in the washing apparatus 26 is cleaned with the pure water of the transfer apparatus (water bearing) 24, part of which forms the washing apparatus 26. This part of the transfer apparatus may be considered as a washing zone. In order to ensure the washing effect, openings 37 and shower nozzles 38 are provided at the bottom and upper part respectively of the washing zone. The used water in the washing zone overflows or is extracted through an exhaust valve 39. The substrates 14 are transferred by water jets issuing from nozzles 31, which are provided on the bottom of the washing zone. The water stream is controlled so that the washing process is finished while the substrate is moving towards the end of the washing zone.

It is desirable, that during the above washing treatment, a single substrate is treated at a time, because, if a new substrate is added into the washing zone while the previous substrate is still in it, the former substrate will be contaminated by the newly-added substrate. But, if the washing zone is very long or if the contamination is not very serious, several substrates may be handled in a same washing zone.

When washing of substrate 14 is completed, the shutter 28b is opened and the substrate is led to a second bucket 33 previously filled with water through water valve 29b, and the water level is adjusted to that of the washing apparatus 26. The substrate 14 is transferred by water bearing to a stopper (not shown). Then shutter 28b and water valve 29b are closed, and the water in the second bucket 33 is exhausted through an exhaust valve 35b. As the water level goes down, the substrate 14 is settled on a chuck 34 of a spin dryer 27. The chuck 34 is lowered beforehand to the bottom of the second bucket 33, in order to receive the substrate 14, and the above-mentioned stopper defines the position of the substrate 14 on the chuck 34.

After the water is drained out, chuck 34 is lifted and begins to rotate around its shaft. The substrate 14 is quickly dried by the spin dryer 27. Then the substrate is shifted by an appropriate robot or manually to be subjected to the next step of processing.

As can be understood from the above explanation, in the processing system according to the present invention, the chemically processed surface of the substrate, which is usually very active and easily poisoned or polluted by ambient air, is kept in pure water until it is dried by the spin dryer; therefore, contamination of the surface is avoided.

In the above embodiment, the substrate is subjected to only one wet processing, but it will be clear for anyone skilled in the art that it would be very easy to link in tandem a plurality of the apparatus such as shown in Fig. 5, and, by varying the processing chemicals in each section of the system, it would be possible to apply any kind of chemical treatments to the substrate in series. In another way, different kinds of chemical treatments can be carried out in a single wet processing apparatus by switching from one chemical to another after each treatment is finished; in this case, the different chemicals are stored in different respective tanks and a switching valve may be provided to switch the processing liquid necessary to a respective treatment to the pump used for running the processing liquid.

## Claims

1. A wet processing apparatus for processing planar substrates, comprising a processing chamber (13) for wet processing a substrate (14) therein, and processing liquid injecting means (15, 16, 20) opening in the lower and upper parts of the processing chamber to cause the substrate to be uniformly processed while being rotated around its center axis by streams of liquid injected into the processing chamber in a direction aslant to the direction of rotation of the substrate, characterized in that the processing chamber comprises:
— a pedestal (11) on which the substrate is processed and comprising: a first opening (15) provided at the center of the pedestal, for injecting processing liquid into the processing chamber through said first opening; a plurality of nozzles (16) provided around said first opening and through which processing liquid is injected into the processing chamber, said nozzles being aslant to the direction of rotation of the substrate (14); and a channel (17') through which processing liquid is supplied to each of said nozzles (16), said channel having a second opening (17) through which processing liquid is admitted; and
— a lid (12) for covering the pedestal (11) and comprising: a third opening (20) through which processing liquid is injected into the processing chamber; and exhaust openings (21) arranged on the periphery of the lid and through which the processing liquid overflows,
— whereby the substrate (14) is floated in the processing liquid while being rotated around its axis.

2. A wet processing apparatus according to claim 1, characterized by an O-ring (22) provided at the periphery of said pedestal (11) for sealing the processing chamber (13) when the lid (12) is pressed down on the pedestal (11).

3. A wet processing apparatus according to claim 1 or 2, characterized by:
— a tank (T) for storing processing liquid;
— a pump (P) for running said processing liquid; and
— a plurality of control valves (B1, B2, B3) for controlling the streams of processing liquid supplied respectively to said first, second and third openings (15, 17, 20).

4. A wet processing apparatus according to claim 3, further characterized by flow meters (F1, F2, F3) each connected to said control valves (B1, B2, B3) respectively, to indicate the flow of liquid through respective control valves.

5. A wet processing apparatus according to claim 3 or 4, further characterized by
— a plurality of tanks each storing a different kind of processing liquid and
a switching valve for switching the processing liquid necessary to a respective processing to said pump.

6. A wet processing installation, for processing planar substrates, characterized in that it comprises:
— a wet processing apparatus according to any one of claims 1 to 5,
— a washing apparatus (26) consisting of a water bearing (24) for simultaneously washing said substrate and transferring it by water jets;
— a spin dryer (27) for drying the substrate;
— a first shutter (28a) which separates or joins the liquid in said washing apparatus (26) from or to the liquid in said processing chamber (13); and
— a second shutter (28b) for separating or joining the liquid in said washing apparatus (26) from or to the water in said spin dryer (27).

7. A wet processing installation according to claim 6, characterized in that said washing apparatus (26) comprises at least one water shower (38) for injecting pure water on the surface of the substrate moving along the water bearing.

8. A wet processing installation according to claim 6 or 7, characterized in that said washing apparatus (26) comprises at least one water inlet (37) arranged at the bottom of said washing apparatus, for supplying pure water to the washing apparatus through said water inlet.

9. A wet processing installation according to any one of claims 6 to 8, characterized in that said washing apparatus (26) comprises a plurality of nozzles (31) arranged at the bottom of said washing apparatus aslant towards the direction of transfer of the substrate, for injecting pure water through said nozzles.

## Patentansprüche

1. Feuchtbearbeitungsvorrichtung zum Bearbeiten planarer Substrate, mit einer Bearbeitungskammer (13) für feuchte Bearbeitung eines Substrates (149) darin, und Bearbeitungsflüssigkeits-Injektionseinrichtungen (15, 16, 20), die sich in die unteren und oberen Teile der Bearbeitungskammer öffnen, um zu bewirken, daß das Substrat gleichmäßig bearbeitet wird, während es um seine zentrale Achse mittels Strömen von Flüssigkeit rotiert wird, die in einer Richtung, die zu der Rotationsrichtung des Substrates geneigt ist, injiziert wird, dadurch gekennzeichnet, daß die Bearbeitungskammer umfaßt:

— einen Untersatz (11), auf dem das Substrat bearbeitet wird, und das umfaßt: eine erste Öffnung (15), die im Zentrum des Untersatzes vorgesehen ist, um Bearbeitungsflüssigkeit durch die genannte erste Öffnung in die Bearbeitungskammer zu injizieren; eine Vielzahl von Düsen (16), die um die genannte erste Öffnung angeordnet sind und durch welche Bearbeitungsflüssigkeit in die Bearbeitungskammer injiziert wird, wobei die genannten Düsen zu der Rotationsrichtung des Substrates (14) geneigt sind; und einen Kanal (17'), durch den Bearbeitungsflüssigkeit zu jeder der genannten Düsen (16) geführt wird, welcher Kanal eine zweite Öffnung (17) hat, durch die Bearbeitungsflüssigkeit eingelassen wird; und

— einen Deckel (12), der den Untersatz (11) bedeckt und umfaßt: eine dritte Öffnung (20), durch die Bearbeitungsflüssigkeit in die Bearbei-tungskammer injiziert wird; und Auslaßöff-nungen (21), die auf dem Umfang des Deckels angeordnet sind und durch die die Bearbeitungsflüssigkeit überfließt;

— wodurch das Substrat (14) in der Bearbeitungsflüssigkeit schwebt, während es um seine Achse rotiert wird.

2. Feuchtbearbeitungsvorrichtung nach Anspruch 1, gekennzeichnet durch einen O-Ring (22), der an dem Umfang des genannten Untersatzes (11) zur Abdichtung der Bearbeitungskammer (13) vorgesehen ist, wenn der Deckel (12) auf den Untersatz (11) runtergepreßt wird.

3. Feuchtbearbeitungsvorrichtung nach Anspruch 1 oder 2, gekennzeichnet durch:

— einen Tank (T) zum Speichern der Bearbeitungsflüssigkeit;

— eine Pumpe (P), um die Bearbeitungsflüssigkeit zu fördern, und

— eine Vielzahl von Steuerventilen (B1, B2, B3) zum Steuern der Ströme von Bearbeitungsflüssigkeit, die der ersten, zweiten bzw. dritten Öffnung (15, 17, 20) zugeführt wird.

4. Feuchtbearbeitungsvorrichtung nach Anspruch 3, ferner gekennzeichnet durch Flußmesser (F1, F2, F3), die jeweils mit den Steuerventilen (B1, B2, B3) verbunden sind, um den Fluß von Flüssigkeit durch die jeweiligen Steuerventile anzuzeigen.

5. Feuchtbearbeitungsvorrichtung nach Anspruch 3 oder 4, ferner gekennzeichnet durch

— eine Vielzahl von Tanks, die jeweils eine Ver-schiedene Art von Bearbeitungsflüssigkeit spei-chern und

ein Schaltventil, um die Bearbeitungsflüssigkeit, die für die jeweilige Bearbeitung erforderlich ist, zu der Pumpe zu schalten.

6. Feuchtbearbeitungsinstallation, zur Bearbeitung planarer Substrate, dadurch gekennzeichnet, daß sie umfaßt:

— eine Feuchtbearbeitungsvorrichtung nach einem der Ansprüche 1 bis 5,

— eine Waschvorrichtung (26), die aus einem Wasserlager (24) besteht, um gleichzeitig das genannte Substrat zu waschen und es durch Wasserström zu transferieren;

— einen Schleudertrockner (27) zum Trocknen des Substrates;

— einen ersten Verschluß (28a), der die Flüssigkeit in der genannten Waschvorrichtung von oder mit der Flüssigkeit in der genannten Bearbeitungskammer (13) trennt, bzw. verbindet; und

— einen zweiten Verschluß (28b) zur Trennung oder Vereinigung der Flüssigkeit in der genannten Waschvorrichtung (26) von oder mit dem Wasser in dem genannten Schleudertrockner (27).

7. Feuchtbearbeitungsinstallation nach Anspruch 6, dadurch gekennzeichnet, daß die genannte Waschvorrichtung (26) wenigstens eine Wasserdusche (38) zum Injizieren von reinem Wasser auf die Oberfläche des Substrats umfaßt, welches sich längs dem Wasserlager bewegt.

8. Feuchtbearbeitungsinstallation nach Anspruch 6 oder 7, dadurch gekennzeichnet, daß die Waschvorrichtung (26) wenigstens einen Wassereinlaß (37) umfaßt, der an der Unterseite der genannten Waschvorrichtung angeordnet ist, um durch den genannten Wassereinlaß reines Wasser zu der Waschvorrichtung zu führen.

9. Feuchtbearbeitungsinstallation nach einem der Ansprüche 6 bis 8, dadurch gekennzeichnet, daß die Waschvorrichtung (26) eine Vielzahl von Düsen (31) umfaßt, die an der Umterseite der genannten Waschvorrichtung zu der Richtung des Transfers des Substrates geneigt angeordnet sind, um reines Wasser durch die genannten Düsen zu injizieren.

**Revendications**

1. Appareil de traitement au mouillé de substrats planaires, comprenant une chambre (13) pour le traitement au mouillé d'un substrat (14) dans cette chambre, ainsi que des moyens d'injection de liquide de traitement (15, 16, 20) débouchant dans la partie inférieure et dans la partie supérieure de la chambre de traitement pour assurer le traitement uniforme du substrat, pendant que celui-ci est tourné autour de son axe par des jets de liquide injecté dans la chambre sous une direction inclinée par rapport à la direction de rotation du substrat, caractérisé en ce que la chambre de traitement est constituée par:

— un socle (11) sur lequel le substrat est traité et qui comporte: une première ouverture (15) prévue au centre du socle pour l'injection de liquide de traitement dans la chambre de traitement; des buses (16) prévues autour de la première ouverture et destinées également à l'injection de liquide de traitement dans cette chambre, les buses étant inclinées par rapport à la direction de rotation du substrat (14); et un canal (17') par lequel du liquide de traitement est amené à chacune des buses (16), ce canal comportant une deuxième ouverture (17) servant à l'admission de liquide de traitement; et

— une couvercle (12) destiné à recevoir le socle (11) et présentant une troisième ouverture (20) pour l'injection de liquide de traitement dans la chambre de traitement, de même que des orifices de sortie (21) ménagés dans le bord du couvercle et par lesquels le liquide de traitement déborde,

— l'agencement étant tel que le substrat (14) est maintenu à l'état flottant dans le liquide de traitement pendant qu'il est tourné autour de son axe.

2. Appareil selon la revendication 1, caractérisé par un joint torique (22) prévu sur le bord du socle et destiné à étancher la chambre de traitement (13) lorsque le couvercle (12) est pressé sur le socle (11).

3. Appareil selon la revendication 1 ou 2, caractérisé par:

— une cuve (T) pour stocker du liquide de traitement;

— une pompe (P) pour débiter ce liquide de traitement; et

— des robinets de réglage ($B_1$, $B_2$, $B_3$) pour régler les débits des courants de liquide de traitement amenés respectivement à la première, la deuxième et la troisième ouverture (15, 17, 20).

4. Appareil selon la revendication 3, caractérisé, en outre, par des débitmètres ($F_1$, $F_2$, $F_3$) raccordés chacun à l'un des robinets de réglage ($B_1$, $B_2$, $B_3$) et servant à indiquer le débit du liquide passant par le robinet de réglage correspondant.

5. Appareil selon la revendication 3 ou 4, caractérisé, en outre, par:

— plusieurs cuves contenant chacune un type différent de liquide de traitement et

— une vanne de commutation pour amener chaque fois le liquide nécessaire à un traitement donné à ladite pompe.

6. Installation pour le traitement au mouillé de substrats planaires, caractérisée en ce qu'elle comprend:

— un appareil de traitement au mouillé selon l'une quelconque des revendications 1 à 5,

— un appareil de lavage (26) consistant en un système de transport hydraulique (24) destiné à assurer simultanément le lavage du substrat et son transfert par des jets d'eau;

— un sécheur centrifuge (27) pour sécher le substrat;

— une première cloison mobile (28a) pour établir la séparation ou la communication entre le liquide dans l'appareil de lavage (26) et le liquide dans la chambre de traitement (13); et

— une seconde cloison mobile (28b) pour établir la séparation ou la communication entre le liquide dans l'appareil de lavage (26) et le liquide dans le sécheur centrifuge (27).

7. Installation selon la revendication 6, caractérisée en ce que l'appareil de lavage (26) comporte au moins un dispositif d'arrosage (38) pour projeter de l'eau pure sur la surface du substrat avançant dans le système de transport hydraulique.

8. Installation selon la revendication 6 ou 7, caractérisée en ce que l'appareil de lavage (26) comporte au moins une arrivée d'eau (37) prévue sur le fond de l'appareil de lavage et servant à l'introduction d'eau pure dans cet appareil.

9. Installation selon l'une quelconque des revendications 6 à 8, caractérisée en ce que l'appareil de lavage (26) comporte des buses (31) disposées sur le fond de l'appareil de lavage, sous une inclinaison par rapport à la direction de transport du substrat, et destinées à l'injection d'eau pure.

**0 130 866**

FIG.1

FIG.2

F I G. 3

(A)

(B)

FIG. 4

(A)

(B)

FIG. 5